# EUROPÄISCHE PATENTANMELDUNG

(11) **EP 2 043 170 A2**
(43) Veröffentlichungstag der Anmeldung: **01.04.2009**
(21) Anmeldenummer: 08105323.3
(22) Anmeldetag: 12.09.2008
(51) Int. Cl.: H01L 41/047, H01L 41/083, H01L 41/22

(54) **Piezoaktormodul mit mehreren untereinander verbundenen Piezoaktoren und ein Verfahren zu dessen Herstellung**

(30) Priorität: 27.09.2007 DE 102007046315
(71) Anmelder: Robert Bosch GmbH, 70469 Stuttgart (DE)
(72) Erfinder: Klotz, Claudia, 96047 Bamberg (DE); Stroehlein, Joerg, 96199 Zapfendorf (DE); Schlegl, Nicole, 73635 Rudersberg (DE); Pohl, Gerd, 02906 Waldhufen Thiemendorf (DE); Martin, Ottmar, 96175 Pettstadt (DE); Schrader, Daniel, 71665 Vaihingen/Enz (DE)

(57) **Zusammenfassung**

Es wird ein Piezoaktormodul (1) mit mindestens zwei in der mechanischen Wirkungsrichtung hintereinander geschalteten Piezoaktoren (2,3) vorgeschlagen, die jeweils aus in der mechanischen Wirkungsrichtung hintereinander geschalteten Piezoelementen mit über Außenelektroden (7,8) kontaktierten Innenelektroden (4,5) wechselnder Polarität bestehen. Es werden hierbei die die jeweils die gleiche Polarität der Innenelektroden (4,5) kontaktierenden Außenelektroden (7,8) der Piezoaktoren (2,3) über eine geometrisch weitgehend homogene Verbindung (10,11;20;30;31,32;7a,8a) elektrisch miteinander kontaktiert. Die Verbindungen können durch einen Draht (10;11), eine einlagige Siebbrücke (20), ein Leitpolymer (30;31;32) oder eine Verlängerung (7a,8a) der Außenelektroden (7,8) gebildet werden.

## Beschreibung

### Stand der Technik

Die Erfindung betrifft ein von flüssigen Medien umströmtes Piezoaktormodul mit einer Anordnung von mehreren mechanisch in Reihe geschalteten Piezoaktoren, vorzugsweise zur Verwendung in einem Piezoinjektor, nach den gattungsgemäßen Merkmalen des Anspruchs 1 und des Verfahrensanspruchs 11.

Ein solcher Piezoinjektor besteht im wesentlichen aus einem Haltekörper und dem in dem Haltekörper angeordneten Piezoaktormodul, das die zwischen einem Kopf- und Fußteil und Anbindebauteilen angeordneten Piezoaktoren aufweist, die jeweils aus mehreren übereinandergestapelten Piezoelementen aufgebaut sind.

Es ist an sich bekannt, dass zum Aufbau des zuvor erwähnten Piezoaktors Piezoelemente so eingesetzt werden können, dass unter Ausnutzung des sogenannten Piezoeffekts eine Steuerung des Nadelhubes eines Ventils oder dergleichen vorgenommen werden kann. Piezolagen der Piezoelemente sind aus einem Material mit einer geeigneten Kristallstruktur so aufgebaut, dass bei Anlage einer äußeren elektrischen Spannung eine mechanische Reaktion des Piezoelements erfolgt, die in Abhängigkeit von der Kristallstruktur und der Anlagebereiche der elektrischen Spannung einen Druck oder Zug in eine vorgebbare Richtung darstellt. Derartige Piezoaktoren eignen sich beispielsweise für Anwendungen, bei denen Hubbewegungen unter hohen Betätigungskräften und hohen Taktfrequenzen ablaufen.

Beispielsweise ist ein solcher Piezoaktor als Bestandteil eines Piezoinjektors in sogenannten Common Rail Einspritzsystemen (CR-Injektor) aus der DE 10026005 A1 bekannt. Bei diesem Piezoaktor sind ebenfalls Piezoelemente als Stapel angeordnet, der über einen Aktorfuß und einen Aktorkopf unter Vorspannung zwischen zwei Anschlägen gehalten ist. Jede Piezolage ist auch hier zwischen zwei Innenelektroden eingefasst, über die von außen eine elektrische Spannung angelegt werden kann. Aufgrund dieser elektrischen Spannung führen die Piezoelemente dann jeweils kleine Hubbewegungen in Richtung des Potenzialgefälles aus, die sich zum Gesamthub des Piezoaktors addieren. Dieser Gesamthub ist über die Höhe der angelegten Spannung veränderbar und kann auf ein mechanisches Stellglied übertragen werden.

Bei diesen bekannten CR-Injektoren ist in der Regel eine indirekt vom Piezoaktormodul gesteuerte Düsennadel als Kraftstoffventil vorhanden, wobei die Piezoaktoren eine Realisierung der Öffnungs-und Schließfunktion ermöglicht. Für eine Anwendung dieser Piezoinjektoren mit direkter Nadelsteuerung in einem Kraftstoffdruck bis zu 2000 bar reicht jedoch der Hub eines einzelnen Piezoaktors nicht zu der direkten Steuerung aus. Der notwendige Mindesthub kann dadurch realisiert werden, dass mindestens zwei oder auch mehrere Piezoaktoren stirnseitig, das heißt in Wirkrichtung, zu einer Aktorreihe aneinandergefügt werden.

Es ist dabei hinlänglich bekannt, dass diese Reihe aus mehreren einzelnen Piezoaktoren beispielsweise zusammengeklebt ist und gekapselt in einer metallischen Hülse das Herzstück des zuvor erläuterten Piezoinjektors bildet. Die elektrische Verbindung der einzelnen Piezoaktoren bzw. deren Außenelektroden zur Kontaktierung der Innenelektroden kann dabei in an sich bekannter Weise beispielsweise durch Spaltschweißen einer elektrisch leitenden Brücke zwischen den Außenelektroden der einzelnen Piezoaktoren realisiert werden. Ein Schutz dieser Reihe von Piezoaktoren gegen den Kraftstoff kann beispielsweise durch eine aus der DE 102 17 361 A1 bekannte dieselresistente Beschichtung, die üblicherweise aus mehreren Schichten mit unterschiedlicher Funktionen besteht, erreicht werden.

Durch das zuvor erwähnte Spaltschweißen und die Brücke, zum Beispiel eine ein- oder mehrfach gefaltete Siebbrücke, ergeben sich Nachteile wahrend des Aufbaus des Piezoaktormoduls sowie für die nachfolgenden Beschichtungsprozesse. Solche Brücken stellen eine geometrische Inhomogenität auf der Außenfläche der Reihe der Piezoaktoren dar, die zu erheblichen Problemen während der Beschichtung mit einem dieselresistenten Material, bestehend aus einer oder mehren Schichten, führt. Solche Brücken stellen auch dadurch ein Risiko für die nachfolgende Beschichtungsschritte dar, da es hierbei schwierig ist, Blasen unter dem Bereich der Schweißstelle Außenelektrode-Brücke zu vermeiden, die dann ein aufwendiges manuelles Verfüllen notwendig machen. Weiterhin kann durch die beschriebene Inhomogenität bei einem Einsatz als Piezoinjektor für die Kraftstoffeinspritzung auch der Kraftstofffluss am Piezoaktormodul vorbei behindert werden.

Offenbarung der Erfindung

Die Erfindung geht von einem Piezoaktormodul mit mindestens zwei in der mechanischen Wirkungsrichtung hintereinander geschalteten Piezoaktoren aus, die für sich gesehen wiederum jeweils aus in der mechanischen Wirkungsrichtung hintereinander geschalteten Piezoelementen mit über Außenelektroden kontaktierten Innenelektroden wechselnder Polarität bestehen. Es werden gemäß der Erfindung in vorteilhafter Weise die jeweils die gleiche Polarität der Innenelektroden kontaktierenden Außenelektroden der aneinander gereihten Piezoaktoren über eine geometrisch weitgehend homogene Verbindung elektrisch miteinander kontaktiert.

Wenn gemäß einer ersten Ausführungsform die Verbindung aus mindestens einem geraden oder gebogenen Draht besteht, der mit den beiden Außenelektroden geometrisch angepasst stoffschlüssig, beispielsweis durch Spalt- oder Laserschweißen, verbunden ist, kann auf einfache Weise sichergestellt werden, dass der leicht an die geometrische Kontur der Außenelektroden anpassbare Draht keine geometrischen Inhomogenitäten verursacht. Des Weiteren wird der notwendige Beschichtungsprozess der Piezoaktoren, bei dem keine Lufteinschlüsse entstehen dürfen, vereinfacht, weil der Raum unterhalb der Verbindung durch die bessere Zugänglichkeit über die relativ dünnen Drähte einfacher verfüllt werden kann.

Bei einer zweiten Ausführungsform der Erfindung besteht die Verbindung aus einer Brücke, zum Beispiel einer einlagigen Siebbrücke, die mit den beiden Außenelektroden (Siebelektroden) geometrisch angepasst stoffschlüssig, beispielsweis durch Spalt- oder Laserschweißen, verbunden ist. Dies ist besonders einfach und wirtschaftlich zu realisieren, da bei einer solchen einlagigen Siebbrücke im Gegensatz zu den aus dem Stand der Technik bekannten gefalteten Siebbrücken Überhöhungen leicht zu vermeiden sind.

Gemäß einer dritten Ausführungsform besteht die Verbindung aus einem Leitpolymer, das bündig oder überlappend in Bereiche zwischen den Piezoaktoren eingebracht und mit den jeweiligen Außenelektroden kontaktiert ist.

Auch hier werden mindestens zwei Piezoaktoren zum Beispiel mit bereits aufgebrachten Außenelektroden (Siebelektroden) zur Bildung des Piezoaktormoduls miteinander verklebt und dann wird anstelle einer metallischen Verbindung nun eine Verbindung durch Auftragen eines Leitpolymers, vorzugsweise eines silbergefüllten Epoxides, realisiert. Dieses Leitpolymer kann beispielsweise mittels eines Druckverfahrens, z.B. Siebdruck, Ink-Jet-Verfahren, etc. , oder eines Spritzverfahrens oder ähnlichem ohne geometrische Inhomogenitäten aufgetragen werden. Hierbei kann ein bündiges Abschließen oder ein überlappender Auftrag gewählt werden, wobei beim überlappenden Auftrag das Leitpolymer in die Siebelektrode hineinfließen kann und somit nicht nach außen hin aufträgt. Darüber hinaus kann der Auftrag des Leitpolymers in einer oder mehreren definierten Linien oder Leiterbahnen nebeneinander oder auch in unterschiedlichen Zusammensetzungen erfolgen. Auch ein mehrmaliger Auftrag übereinander, zum Beispiel mit verschiedenen Leitpolymerzusammensetzungen, ist hier vorteilhaft möglich.

Der Vorteil der letztgenannten Ausführungsform liegt vor allem darin, dass der Auftrag des Leitpolymers zum einen sehr einfach realisiert werden kann und zum anderen Längen- bzw. Lagetoleranzen der serienmäßigen Siebelektroden als Außenelektroden ausgeglichen werden können. Darüber hinaus kann das Leitpolymer auch den Zwischenraum zwischen den Piezoaktoren vollständig ausfüllen, so dass für den weiteren Beschichtungsprozess kein Hinterfüllen notwendig ist. Durch einen mehrlagigen Auftrag kann die Grenzfläche sowohl zum Piezoaktor als auch zur eventuell noch aufzubringenden Beschichtung geometrisch angepasst modifiziert werden und durch den entsprechenden Auftrag von Leiterbahnen kann auch der elektrische Widerstand durch die Materialauswahl gezielt eingestellt werden. Auf jeden Fall entfällt der bisher notwendige Schweiß- oder Lötprozess im aktiven Bereich des Piezoaktors mit allen damit verbundenen Nachteilen.

Bei einer vierten Ausführungsform der Erfindung wird die Verbindung jeweils durch eine vorgegebene Verlängerung der Außenelektroden zum anliegenden Piezoaktor derart hergestellt, dass eine stoffschlüssige Verbindung zwischen der Verlängerung und der anliegenden Außenelektrode des anderen Piezoaktors herstellbar ist. Hier werden somit mindestens zwei Piezoaktoren mit verlängertem Sieb so zueinander positioniert, dass die Stirnseiten der Piezoaktoren mit den Verlängerungen möglichst spaltfrei zueinander stehen. Die sich durch die Verlängerung ausbildende Überstände werden dann stirnseitig miteinander stoffschlüssig verbunden, vorzugsweise auch hier durch Spalt- oder Laserschweißen. Eine solche Schweißung erfolgt hier somit im inaktiven Bereich der Piezoaktoren und geometrische Inhomogenitäten durch ein zusätzliches Verbindungselement und die damit verbundenen Nachteile entfallen auch hier.

Weiterhin wird ein vorteilhaftes Verfahren zur Herstellung eines der vorher beschriebenen Piezoaktormodule vorgeschlagen, bei dem in einem ersten Verfahrensschritt die einzelnen Piezoaktoren mit den jeweiligen zum Beispiel aufgelöteten, zum Beispiel Dampfphasenlöten, Außenelektroden stoffschlüssig aneinandergefügt werden und in einem zweiten Verfahrensschritt werden die Außenelektroden jeweils gleicher Polarität miteinander gemäß der zuvor beschriebenen erfindungemäßen Ausführungsformen kontaktiert.

Kurze Beschreibung der Zeichnungen
Ausführungsbeispiele des erfindungsgemäßen Piezoaktormoduls werden anhand der Zeichnung erläutert. Es zeigen:
- Figur 1: einen Schnitt durch zwei aneinander gereihte Piezoaktoren für ein Piezoaktormodul, die in bekannter Weise mittels einer Brücke miteinander verbunden sind,
- Figur 2: eine Ansicht auf zwei aneinander gereihte Piezoaktoren, die erfindungsgemäß mit einem Draht miteinander kontaktiert sind,
- Figur 3: eine Ansicht auf eine Abwandlung des Ausführungsbeispiels nach der Figur 2 mit zwei Drähten,
- Figur 4: eine Ansicht auf eine Abwandlung des Ausführungsbeispiels nach der Figur 2 mit einem gebogenen Draht,
- Figur 5: eine Ansicht auf zwei aneinander gereihte Piezoaktoren, die erfindungsgemäß mit einer einlagigen Siebbrücke miteinander kontaktiert sind,
- Figur 6: eine Ansicht auf zwei aneinander gereihte Piezoaktoren, die erfindungsgemäß mit einem bündigen Leitpolymer miteinander kontaktiert sind,
- Figur 7: eine Ansicht auf eine Abwandlung des Ausführungsbeispiels nach der Figur 6 mit einem überlappenden Leitpolymer,
- Figur 8: eine Ansicht auf eine Abwandlung des Ausführungsbeispiels nach der Figur 6 mit zwei einzelnen Streifen eines Leitpolymers,
- Figur 9: einen Schnitt durch die Anordnung nach der Figur 6,
- Figur 10: einen Schnitt durch die Anordnung nach der Figur 7,
- Figur 11: eine Ansicht auf einen Piezoaktor, der erfindungsgemäß über eine Verlängerung einer Außenelektrode mit einem weiteren Piezoaktor kontaktierbar ist,
- Figur 12: eine Ansicht auf zwei aneinander gereihte Piezoaktoren, die erfindungsgemäß über eine Verlängerung einer Außenelektrode nach der Figur 11 miteinander kontaktiert sind und
- Figur 13: einen Schnitt durch die Anordnung nach der Figur 12.

### Ausführungsformen der Erfindung

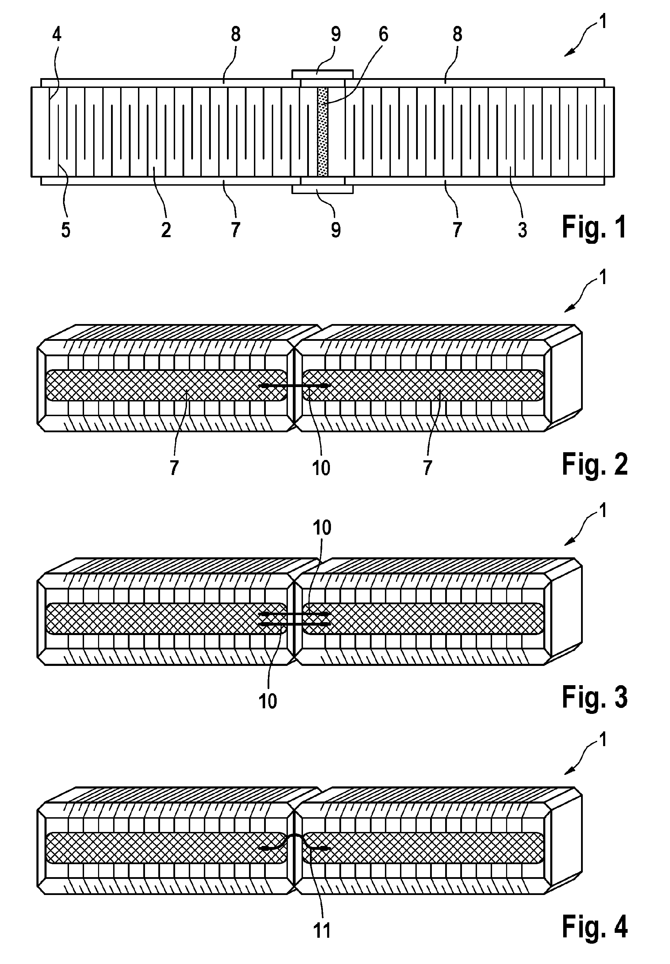

Im Folgenden wird ein Piezoaktormodul 1 erläutert, das beispielsweise für einen Piezoinjektor zur Nadelhubsteuerung in einem Einspritzsystem für Kraftstoff bei einem Verbrennungsmotor eingesetzt werden kann, wie es eingangs anhand des Standes der Technik beschrieben ist. Figur 1 zeigt zur Erläuterung der Nachteile des Standes der Technik eine herkömmliche Verbindung von zwei Piezoaktoren 2 und 3 im Piezoaktormodul 1.

Hierzu sind der Piezoaktor 2 und der Piezoaktor 3 in der mechanischen Wirkrichtung hintereinander geschaltet, so dass mit den in der Beschreibungseinleitung beschriebenen Piezoelementen ein mechanischer Hub in der Längserstreckung des Piezoaktormoduls 1 bewirkt werden kann. Die Piezoelemente werden durch Innenelektroden 4 der einen Polarität und Innenelektroden 5 der jeweils anderen Polarität und den dazwischenliegenden Piezolagen gebildet, wobei hier der Übersichtlichkeit wegen nur ein solches Piezoelement am linken Ende des Piezoaktors 2 mit den entsprechenden Bezugszeichen versehen worden ist. Beide Piezoaktoren 2 und 3 sind an den Stirnseiten mittels einer Klebestelle 6 stoffschlüssig miteinander verbunden.

Die Piezoaktoren 2 und 3 des Piezoaktormoduls 1 weisen jeweils Außenelektroden 7 und 8, Beispielswiese Siebelektroden, auf. Die Außenelektrode 7 kontaktiert hier jeweils die Innenelektroden 5 und die Außenelektrode 8 kontaktiert hier jeweils die Innenelektroden 4. Die Außenelektroden 7 und 8 können dabei mittels einer Dampfphasenlötung schon vor dem Zusammenfügen der Piezoaktoren 2 und 3 elektrisch leitend aufgebracht werden. Zur Verbindung der Außenelektroden 7 oder 8 der jeweils gleichen Polarität sind Brücken 9, zum Beispiel Siebbrücken, vorhanden, die beispielsweise durch Spalt- oder Laserschweißen mit den jeweiligen Außenelektroden 7 oder 8 kontaktiert sind. Diese bekannten Brücken 9 nach der Figur 1 bestehen in der Regel aus gefalteten Sieben und ragen daher einen gewissen Bereich aus der geometrischen Kontur der Piezoaktoren 2 und 3 heraus und bilden daher die in der Beschreibungseinleitung als nachteilig herausgestellten Inhomogenitäten.

Figur 2 zeigt ein Ausführungsbeispiel des erfindungsgemäßen Piezoaktormoduls 1, bei dem die in der Figur 1 vorhanden Brücken 9 wegfallen und die Verbindungen der Außenelektroden 7 oder 8 mittels eines Drahtes 10 hergestellt sind, der hier sichtbar jeweils an der Außenelektrode 7 des Piezoaktors 2 und des Piezoaktors 3 beispielsweise durch Spalt- der Laserschweißen elektrisch leitend angefügt ist. Der Draht 10 kann auf einfache Weise derart in die Geometrie der Außenelektrode 7 oder 8 eingefügt werden, dass hier keine Störung der Homogenität der Außenkontur der Piezoaktoren erfolgt.

Aus Figur 3 ist noch ein Ausführungsbeispiel mit zwei Drähten 10 und in Figur 4 ist ein Ausführungsbeispiel mit einem gebogenen Draht 11 gezeigt, die jeweils die mechanische Flexibilität oder Stabilität noch verbessern können. Für gleich wirkende Elemente in den Figuren 2 bis 4 sind jeweils die gleichen Bezugszeichen wie in der Figur 1 verwendet worden.

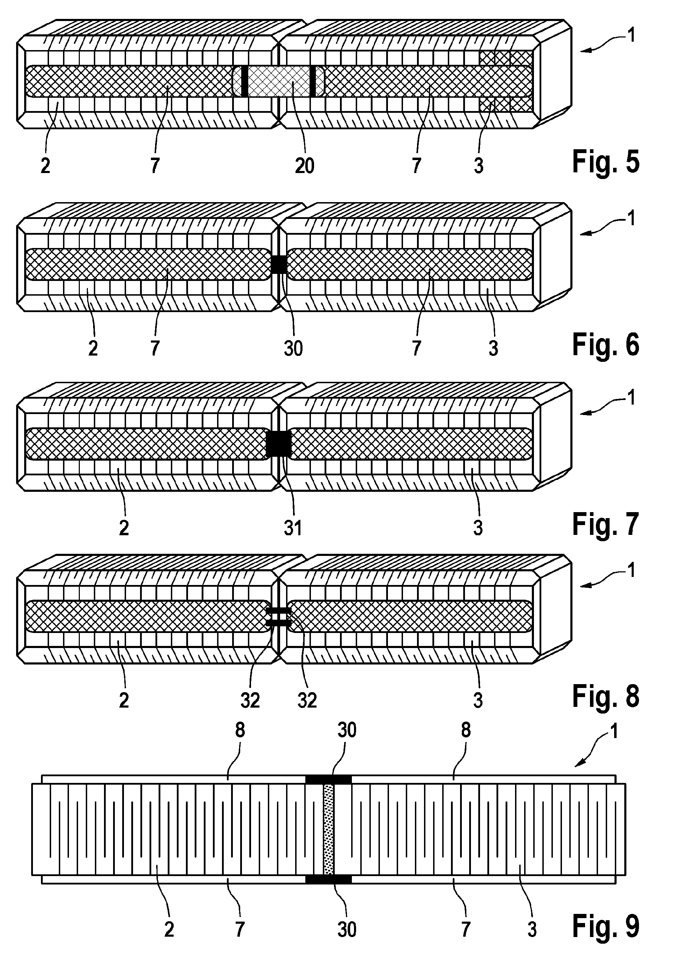

Figur 5 zeigt ein zweites Ausführungsbeispiel der Erfindung, bei dem ein einfaches ungefaltetes Sieb 20 als Verbindung zwischen den Außenelektroden 7 und/oder 8 (hier sichtbar nur die Verbindung zwischen den Außenelektroden 7) angebracht ist. Dieses einlagige Sieb 20 kann einfach in die Kontur der Außenelektroden 7 und 8 eingefügt und an den Enden spalt- oder lasergeschweißt werden, ohne die Homogenität der Kontur der Piezoaktoren 2 und 3 zu stören.

In Figur 6 ist ein drittes Ausführungsbeispiel der Erfindung gezeigt, bei dem die Verbindung der Außenelektroden 7 und/oder 8 zwischen den Piezoaktoren 2 und 3 aus einem Leitpolymer 30 besteht, das hier bündig mit den jeweiligen sichtbaren Außenelektroden 7 kontaktiert ist, wie es aus dem entsprechenden Schnitt nach Figur 9 zu entnehmen ist. Dieses Leitpolymer 30 kann beispielsweise mittels eines Druckverfahrens, z.B. Siebdruck, Ink-Jet-Verfahren, etc., oder eines Spritzverfahrens oder ähnlichem ohne geometrische Unstetigkeiten aufgetragen werden.

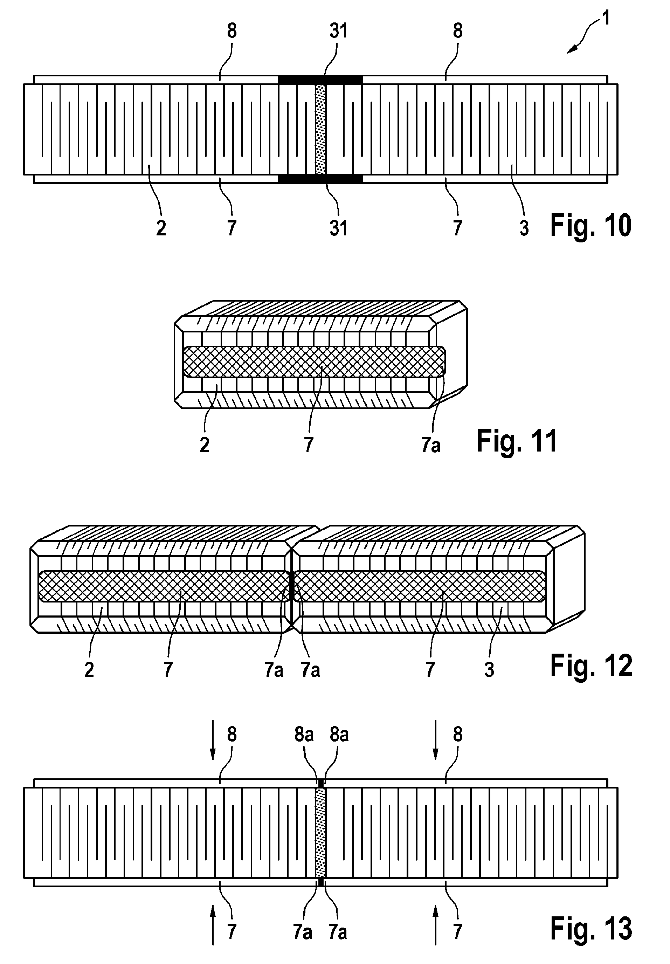

Figur 7 zeigt eine Abwandlung des Ausführungsbeispiels nach der Figur 6, bei der ein Leitpolymer 31 als Verbindung mit einem überlappenden Auftrag gewählt ist, wobei hier das Leitpolymer 31 in die als Siebelektrode ausgeführte Außenelektrode 7 hineinfließen kann und somit nicht nach außen hin aufträgt, wie es aus dem entsprechenden Schnitt nach Figur 10 zu entnehmen ist.

Darüber hinaus kann der Auftrag des Leitpolymers nach Figur 8 auch in einer oder mehreren definierten Linien oder Leiterbahnen 32 nebeneinander oder auch in unterschiedlichen Zusammensetzungen erfolgen. Auch ein mehrmaliger Auftrag übereinander, zum Beispiel mit verschiedenen Leitpolymerzusammensetzungen ist hier vorteilhaft möglich.

Ein viertes Ausführungsbeispiel der Erfindung ist in Figur 11 gezeigt, bei dem die Verbindung der Außenelektroden 7 und/oder 8 der jeweiligen Piezoaktoren 2 und 3 jeweils in der hier sichtbaren Form durch eine vorgegebene einseitige Verlängerung 7a der Außenelektrode 7 zum anliegenden Piezoaktor hergestellt ist. Somit kann, wie aus der Ansicht nach Figur 12 und dem entsprechenden Schnitt nach Figur 13 erkennbar, eine stoffschlüssige Verbindung zwischen den Verlängerungen 7a oder 8a der jeweils aneinanderliegenden Außenelektroden 7 oder 8 hergestellt werden. Die sich durch die Verlängerungen 7a oder 8a ausbildenden Überstände werden dann stirnseitig miteinander stoffschlüssig verbunden, vorzugsweise auch hier durch Spalt- oder Laserschweißen, das sich hier jedoch im inaktiven Bereich der Piezoaktoren 2 und 3 abspielt.

## Patentansprüche

1. Piezoaktormodul mit mindestens zwei in der mechanischen Wirkungsrichtung hintereinander geschalteten Piezoaktoren (2,3), die jeweils aus in der mechanischen Wirkungsrichtung hintereinander geschalteten Piezoelementen mit über Außenelektroden (7,8) kontaktierten Innenelektroden (4,5) wechselnder Polarität bestehen, **dadurch gekennzeichnet, dass** die jeweils die gleiche Polarität der Innenelektroden (4,5) kontaktierenden Außenelektroden (7,8) der Piezoaktoren (2,3) über eine geometrisch weitgehend homogene Verbindung (10,11;20; 30;31,32;7a,8a) elektrisch miteinander kontaktiert sind.

2. Piezoaktormodul nach Anspruch 1, **dadurch gekennzeichnet, dass** die Verbindung aus mindestens einem Draht (10) besteht, der mit den beiden Außenelektroden (7,8) geometrisch angepasst stoffschlüssig verbunden ist.

3. Piezoaktormodul nach Anspruch 2, **dadurch gekennzeichnet, dass** der mindestens eine Draht (11) in der Ebene der Außenelektroden (7,8) zwischen den Außenelektroden (7,8) gebogen ist.

4. Piezoaktormodul nach Anspruch 1, **dadurch gekennzeichnet, dass** die Verbindung aus einer einlagigen Brücke (20) besteht, die mit den beiden Außenelektroden (7,8) geometrisch angepasst stoffschlüssig verbunden ist.

5. Piezoaktormodul nach Anspruch 1, **dadurch gekennzeichnet, dass** die Verbindung aus einem Leitpolymer (30;31;32) besteht, das bündig oder überlappend mit den jeweiligen Außenelektroden (7,8) kontaktiert ist.

6. Piezoaktormodul nach Anspruch 1, **dadurch gekennzeichnet, dass** die Verbindung aus einem Leitpolymer (30;31;32) in einem oder mehreren Streifen aufgetragen ist und dass Leiterbahnen integrierbar sind.

7. Piezoaktormodul nach Anspruch 1, **dadurch gekennzeichnet, dass** die Verbindung jeweils durch eine vorgegebene Verlängerung (7a,8a) der Außenelektroden (7,8) zum jeweils anliegenden Piezoaktor(2,3) derart hergestellt ist, dass eine stoffschlüssige Verbindung zwischen den Verlängerungen (7a,8a) und den Außenelektroden (7,8) herstellbar ist.

8. Piezoaktormodul nach einem der vorhergehnden Ansprüche, **dadurch gekennzeichnet, dass** die Piezoaktoren (2,3) stirnseitig über eine Klebeverbindung miteinander verbunden sind.

9. Piezoaktormodul nach einem der vorhergehenden Ansprüche, **dadurch gekennzeichnet, dass** die Außenelektroden (7,8) metallische Siebelektroden sind.

10. Piezoaktormodul nach Anspruch 5 oder 6 in Verbindung mit Anspruch 9, **dadurch gekennzeichnet, dass** das Leitpolymer bei einer überlappenden Verbindung in die jeweilige Siebelektrode hineingeflossen ist.

11. Verfahren zur Herstellung eines Piezoaktormoduls nach einem der vorhergehenden Ansprüche, **dadurch gekennzeichnet, dass** in einem ersten Verfahrensschritt die einzelnen Piezoaktoren (2,3) mit den jeweiligen Außenelektroden (7,8) stoffschlüssig aneinandergefügt werden und in einem zweiten Verfahrensschritt die Außenelektroden (7,8) jeweils gleicher Polarität miteinander kontaktiert werden.

12. Verfahren nach Anspruch 11 in Verbindung mit Anspruch 2 , 3, 4 oder 6, **dadurch gekennzeichnet, dass** im zweiten Verfahrensschritt der mindestens eine Draht (10,11), die Brücke (20) oder die verlängerten Außenelektroden (7,7a,8,8a) durch Spalt- oder Laserschweißen kontaktiert werden.

13. Verfahren nach Anspruch 11 in Verbindung mit Anspruch 5, 6 oder 9, **dadurch gekennzeichnet, dass** im zweiten Verfahrensschritt das Leitpolymer und/oder die Leiterbahnen (30;31;32) in einem Druck- oder Spritzverfahren aufgetragen werden.
